Europäisches Patentamt

European Patent Office

Office européen des brevets

(11) Publication number: **0 154 501**
**A2**

## (12) EUROPEAN PATENT APPLICATION

(21) Application number: **85301313.4**

(22) Date of filing: **27.02.85**

(51) Int. Cl.⁴: **H 03 K 19/094**

(30) Priority: **29.02.84 JP 37459/84**

(43) Date of publication of application:
**11.09.85 Bulletin 85/37**

(84) Designated Contracting States:
**DE FR GB IT**

(71) Applicant: **FUJITSU LIMITED**
**1015, Kamikodanaka Nakahara-ku**
**Kawasaki-shi Kanagawa 211(JP)**

(72) Inventor: **Suyama, Katsuhiko**
**11-7, Kikuna 1-chome Kohoku-ku**
**Yokohama-shi Kanagawa 222(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **Logic circuit.**

(57) A logic circuit includes a pair of transistors formed by junction type or Schottky barrier type field effect transistors $(Q_1, Q_2)$, a constant current electric source $(Q_3)$ connected to a common source terminal of the field effect transistor $(Q_1, Q_2)$, and a pair of load elements $(R_1, R_2)$ respectively connected between each drain terminal of the field effect transistors $(Q_1, Q_2)$ and an electric source $(V_{DD})$. A clamp circuit $(D_1, D_2)$ is connected between the drain terminals of the pair of field effect transistors.

*Fig. 4*

EP 0 154 501 A2

LOGIC CIRCUIT

The present invention concerns a differential amplifier circuit formed by a junction type or Schottky barrier gate type field effect transistor (MESFET) mounted on an integrated circuit using/a gallium arsenide (GaAs) substrate.
for example

In an integrated circuit using a GaAs substrate, it is difficult to form a MOSFET on the substrate since the gate insulation film is not easily deposited, and therefore, junction type or Schottky barrier gate type elements are used as the field effect transistors (FET's). That is, in a logic circuit formed by FET's, all transistors in the circuit are formed by junction type or Schottky barrier gate type FET's.

However, as explained hereinafter in detail, in a logic circuit formed by junction type or Schottky barrier gate type FET's, the low level output may be unstable. To prevent this unstableness from occurring, a power supply voltage is raised or a constant current or the load is decreased. However, if the former method is used, power consumption is increased, and if the latter method is used, the voltage gain of the circuit is decreased.

An embodiment of the present invention can remove unstableness in the low level in the logic circuit formed as mentioned above, to increase the voltage gain, to maintain a low electric power consumption, and to effect a rapid response speed.

In accordance with the present invention, there is provided a logic circuit comprising a pair of transistors formed by junction type or Schottky barrier type FET's, a constant current source connected to a common source terminal of the FET's, a pair of loads respectively connected between each drain terminal of the FET's and a power supply, and a clamp circuit connected between the drain terminals of the FET's.

Reference is made, by way of example, to the accompanying drawings in which:

Figure 1 is a diagram of a circuit showing one example of a conventional differential circuit using junction type FET's;

Fig. 2 is a diagram showing a direct current transfer characteristic in the circuit shown in Fig. 1;

Figs. 3A to 3F are diagrams explaining field effect transistors;

Fig. 4 is a circuit diagram showing one embodiment of the present invention;

Fig. 5 is a circuit diagram showing a modification of the embodiment in Fig. 4;

Fig. 6 is a diagram showing direct current transfer characteristics in a circuit according to the present invention;

Fig. 7 is a diagram explaining     turn OFF response characteristics;

Fig. 8 is a diagram of a circuit showing another embodiment of the present invention; and

Fig. 9 is a diagram of a circuit showing still another embodiment of the present invention.

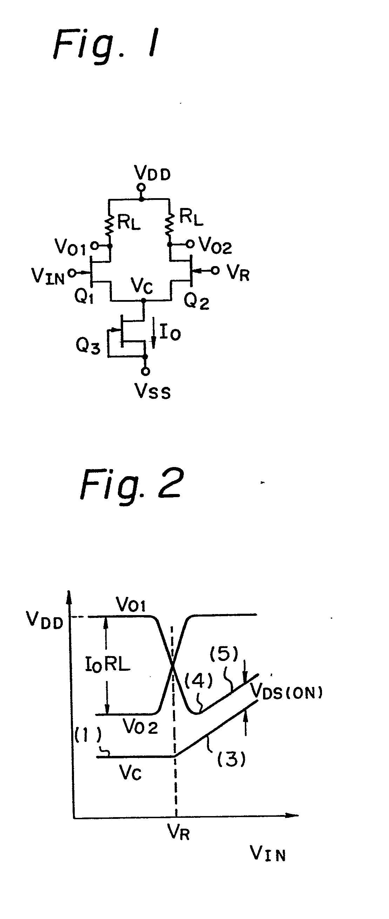

As mentioned previously, in an integrated circuit using a GaAs substrate, it is difficult to form a MOSFET since the gate insulation film is not easily deposited, and thus junction type or Schottky barrier gate type elements are used as the FET's. When     a differential amplifier circuit is formed, the circuit can be constituted as shown in Fig. 1. Conventionally, this type of circuit is used when the differential circuit is formed by a bipolar transistor or MOS transistor using a usual silicon (Si) substrate. However, the characteristic feature of the circuit shown in Fig. 1 is that all the transistors in the circuit may/junction type or Schottky barrier type FET's formed on a GaAs substrate.

The differential circuit shown in Fig. 1 is formed by a pair of driver FET's $Q_1$ , $Q_2$ , with load resistors $R_L$ , $R_L$ connected to the drains of the FET's $Q_1$ , $Q_2$ , and a constant current FET $Q_3$ connected to a common source of the FET's $Q_1$ , $Q_2$. In the Figure, $V_{DD}$ is a high power supply voltage, $V_{SS}$ is a low power supply voltage, $I_0$ is a constant current flowing in the constant current source, $V_R$ is a reference voltage, $V_{IN}$ is an input voltage, and $V_{01}$ , $V_{02}$ are complementary output voltages.

The FET's $Q_1 \sim Q_3$ are all n channel type transistors; $Q_1$ , $Q_2$ being enhancement or depletion type transistors and $Q_3$ being a depletion type transistor. In the circuit shown in Fig. 1, when the input $V_{IN}$ is sufficiently lower than the reference voltage $V_R$ , $Q_1$ is in an OFF state, and $Q_2$ is in an ON state. In this case, the gate junction of $Q_2$ becomes conductive, and thus the voltage $V_C$ at the common source terminal is as shown in the following:

$$V_C = V_R - V_{bi} \qquad (1)$$

Where, $V_{bi}$ is a built-in voltage of the gate junction. Then, since the constant current $I_0$ flows to the load resistor $R_L$ in the $Q_2$ side, the output terminal voltage becomes

$$V_{02} = V_{DD} - I_0 \cdot R_L \qquad (2)$$
$$V_{01} = V_{DD} \qquad (2)'$$

Conversely, when the input voltage $V_{IN}$ becomes sufficiently higher than the reference voltage $V_R$ , $Q_1$ becomes ON and $Q_2$ becomes OFF, and therefore, the following relationships are established:

$$V_C = V_{IN} - V_{bi} \qquad (3)$$

$$V_{01} = V_{DD} - I_0 \cdot R_L \qquad\qquad (4)$$
$$V_{02} = V_{DD} \qquad\qquad (4)'$$

In this case, for flow of constant current $I_0$ through $Q_1$, a voltage of about 0.2 volts is required as the voltage $V_{DS(ON)}$ (see Fig. 2) between the drain and source of $Q_1$, as shown below,

$$V_{01} - V_C \gtrsim V_{DS(ON)}$$

Therefore, when the input $V_{IN}$ becomes high and the common source voltage $V_C$ approaches $V_{01}$, $V_{01}$ is lifted by $V_{IN}$ and the low level becomes unstable.

Figure 2 shows a direct current transfer characteristic of the differential amplifier circuit shown in Fig. 1. That is, in the region $V_{IN} > V_R$, the common source voltage $V_C$ increases in accordance with the relationship established in equation (3), therefore, the low (L) level output $V_{01}$ is increased in accordance with the following relationship.

$$V_{01} = V_C + V_{DS(ON)} = V_{IN} - V_{bi} + V_{DS(ON)} \qquad (5)$$

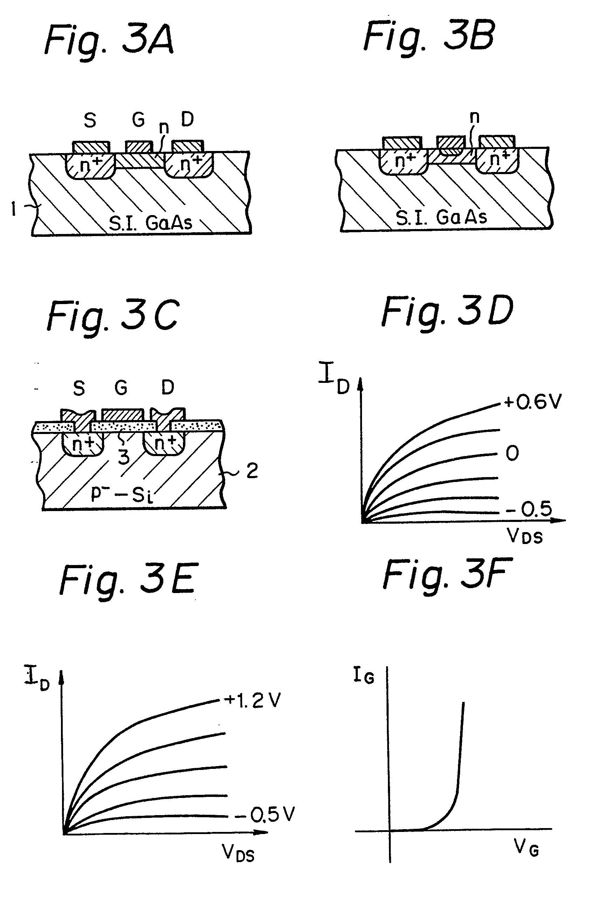

This phenomenon occurs because of the element construction of the FET's, and is explained by Figs. 3A to 3F. Figures 3A and 3B show junction and Schottky barrier gate type FET's (hereinafter referred to as junction type FET's), and Fig. 3C shows a MOSFET. The substrate 1 of the junction type FET is formed by GaAs and is insulative, and thus impurities are doped in the source, drain, and channel regions to ensure conductivity. A source electrode S and a drain electrode D are attached to the source drain regions $n^+$, $n^+$, and a gate electrode G is attached to the channel region n. In Figs. 3A and 3B, AuGe is used for the electrodes S and D, and WSi is used for the gate electrode G. In Fig. 3C, the substrate 2 of the MOSFET is made from Si, and is different from the above in that a gate oxide film ($SiO_2$) 3 is sandwiched between the gate electrode G and the substrate 2. Figure 3D shows a characteristic between the drain-source voltage $V_{DS}$ of the junction type FET and the drain current $I_D$, and Figure 3E shows a characteristic between the drain-source voltage $V_{DS}$ of the Schottky barrier type FET and the drain current $I_D$. In Figs. 3D and 3E, the gate voltage is used as the parameter. Figure 3F shows the voltage current characteristic of the gate of the junction type FET. As can be seen in the Figure, when the gate voltage $V_G$ is raised higher than the predetermined voltage, a gate junction current flows. This is a normal diode characteristic. The drain current $I_D$ flowing in the FET when in the ON state has the relationship shown below where the current amplification factor is $\beta$, the voltage between gate and source is $V_{GS}$, and the threshold voltage is Vth;

$$I_D = \beta (V_{GS} - Vth)^2$$

In Fig. 1, this $I_D$ is a constant current $I_0$, and $V_{GS} = V_{IN} - V_C$, therefore, the above-mentioned equation becomes:

$$I_0 = \beta (V_{IN} - V_C - Vth)^2$$

$V_C$ is obtained from this equation as follows:

$$V_C = V_{IN} - Vth - \sqrt{\frac{I_0}{\beta}}$$

Thus, as shown above, $V_C$ varies in accordance with the input $V_{IN}$.

To deal with this, ① the electric source voltage $V_{DD}$ is set high, or ② the constant current $I_0$ or the load resistor $R_L$ is set low, so that, as is clear from equation (4), the L level of $V_{01}$ is raised. Thereby, as shown in Fig. 2, $V_C$ in the region in which $V_{IN}$ is higher than $V_R$ does not raise the L level of $V_{01}$. However, the disadvantages of the above are, when method ① is used, the power dissipation is increased, and when method ② is used, the voltage gain is decreased.

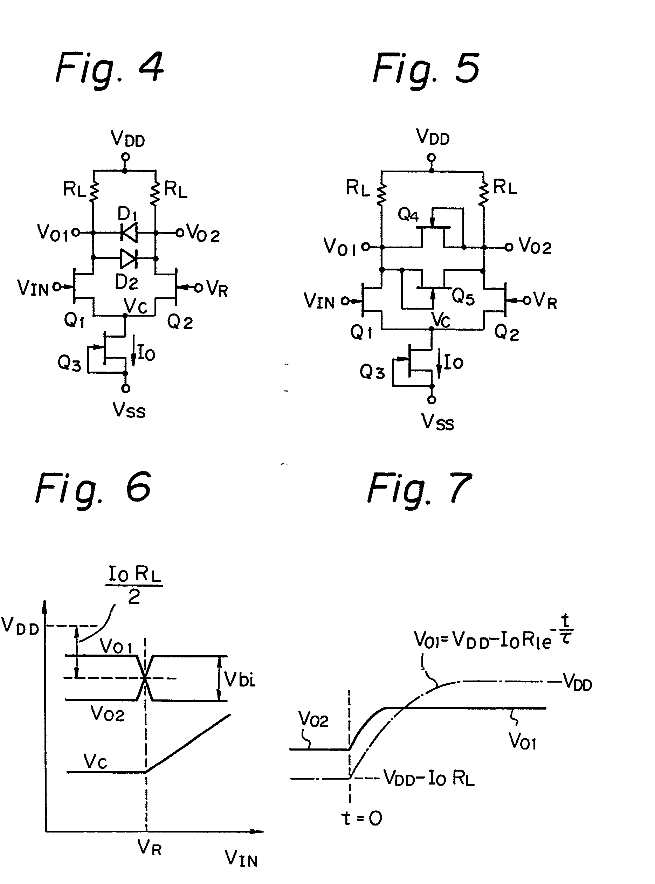

Figure 4 is a circuit diagram showing one embodiment of the present invention, wherein the same elements as shown in Fig. 1 are referred to by the same symbols. This circuit is different from that of Fig. 1 in that a

- 6 -                    **0154501**

pair of diodes $D_1$ , $D_2$ , which are connected in parallel with opposite polarity, are connected between the drains of the driving FET's $Q_1$ , $Q_2$ , that is, between output terminals. In the circuit shown in Fig. 5, the FET's $Q_4$ , $Q_5$ , in each of which the gate is connected to the drain, are used instead of the diodes $D_1$ , $D_2$ of Fig. 4.

Figure 6 shows a direct current transfer characteristic, and as shown in the Figure, the L level of the output $V_{01}$ is not raised. Variation of the common source potential $V_C$ for the input voltage $V_{IN}$ is the same as that shown in Fig. 2. The diodes $D_1$ or $D_2$ become conductive when the potential difference between the anode and the cathode becomes large. The potential difference is restricted to $V_{bi}$ , and the maximum value thereof becomes as follows:

$$|V_{01} - V_{02}| = V_{bi} \qquad (6)$$

The diodes $D_1$ , $D_2$ have the same gate construction as that of the FET's. Therefore, the builtin voltage $V_{bi}$ becomes the same as shown by equation (1). (When a GaAs MES-FET is used, $V_{bi}$ = 0.7 V). $|V_{01} - V_{02}|$ is equal to $V_{bi}$ , that is the output amplitude is restricted by the diodes $D_1$ , $D_2$ , whereby the low limit ("L" level) is raised, and thus the rising (of $V_{01}$ "L" level) due to $V_C$ can be avoided.

The operation of the above circuit will now be explained. When the input voltage $V_{IN}$ is lower than the reference voltage $V_R$ , $Q_1$ is OFF and $Q_2$ is made ON, as shown in Fig. 1. However, in the present invention, the diode $D_2$ is made ON by $V_{01} > V_{02}$ , when $V_{01}$ is higher by $V_{b1}$ than $V_{02}$. Therefore, the following relationships are established:

$$V_{01} = V_{DD} - \frac{I_0 R_L}{2} + \frac{V_{bi}}{2} \qquad (7)$$

$$V_{02} = V_{DD} - \frac{I_0 R_L}{2} - \frac{V_{bi}}{2} \qquad (8)$$

Conversely, when $V_{IN} > V_R$ , $Q_1$ is made ON and $Q_2$ is made OFF. Thus, where $V_{01} < V_{02}$ , the diode $D_1$ is made ON. At this time, the levels of $V_{01}$ , $V_{02}$ have an inverse relationship to those given in equations (7) and (8). Figure 6 shows the relationships between $V_{01}$ , $V_{02}$ , $V_{DD}$ , $I_0 R_L/2$, and $V_{bi}$. Accordingly, a differential amplifier circuit having a symmetrical transfer characteristic and a stable low level can be obtained. As shown in the drawing, the potential difference between the electric source $V_{DD}$ and the middle point of the output is $I_0 \cdot R_L/2$, and thus the voltage gain can be increased by increasing the $I_0$ or $R_L$. In particular, when $I_0$ is increased, the response characteristic for driving a capacitive load can be increased. Further, the operation can be accelerated in accordance with the amount of the decrease in the output amplitude.

A concrete embodiment of the invention will now be explained. In Fig. 4, it is assumed that $R_L$ = 5 kΩ, $V_{DD}$ = +2.5 V, and $V_{SS}$ = -2.5 V, and the constant of each element is assumed as shown in the following table. In this example, — diodes $D_1$ , $D_2$ are formed by connecting the source and the drain of an FET so as to form the cathode and the anode (the gate electrode is used as the anode electrode).

TABLE 1

|  | Vth | GATE LENGTH | GATE WIDTH |
|---|---|---|---|
| $Q_1$ , $Q_2$ | +0.1 V | 1 μm | 40 μm |
| $Q_3$ | -0.6 V | 1 μm | 20 μm |
| $D_1$ , $D_2$ | -0.6 V | 1 μm | 10 μm |

With these values, as the switching characteristic, the turn ON delay time becomes 0.4 ns, the turn OFF delay time becomes 0.8 ns, and the mean delay time becomes 0.6 ns. When the diodes $D_1$ , $D_2$ are not used (as in the prior art), the turn ON delay time becomes 0.7 ns, the turn OFF delay time becomes 1.9 ns and the mean delay time becomes 1.3 ns; and thus the response characteristic is inferior. In particular, the length of the turn OFF delay time is due to the fact that the output response is determined by the time constant of the load resistor $R_L$ and the capacitive load. In the embodiment, when the input $V_{IN}$ changes from a high (H) level to an L level, the output $V_{01}$ increases toward an asymptotic line, as shown by a solid line in Fig. 7. The time constant of this increase is the same as that of he prior art (shown by a chain line in the Figure), however, when it reaches the value shown in equation 7, and the diode $D_2$ becomes conductive and $V_{01}$/is clamped at the level thereof. In the turn ON time, the load capacitance is discharged by the constant current $I_0$ flowing in $Q_1$ (or $Q_2$), and thus the response is more rapid than that in the turn OFF time. In this embodiment, the output amplitude is about half of the normal amplitude, and therefore, the delay time is short, i.e., is in proportion to the smaller output amplitude. As shown in this embodiment, the present invention has an effect in which the voltage gain is increased and the response speed is accelerated. Further, since an FET in which the drain and the source is short circuited is used as the diode, the manufacturing process is the same as the conventional process.

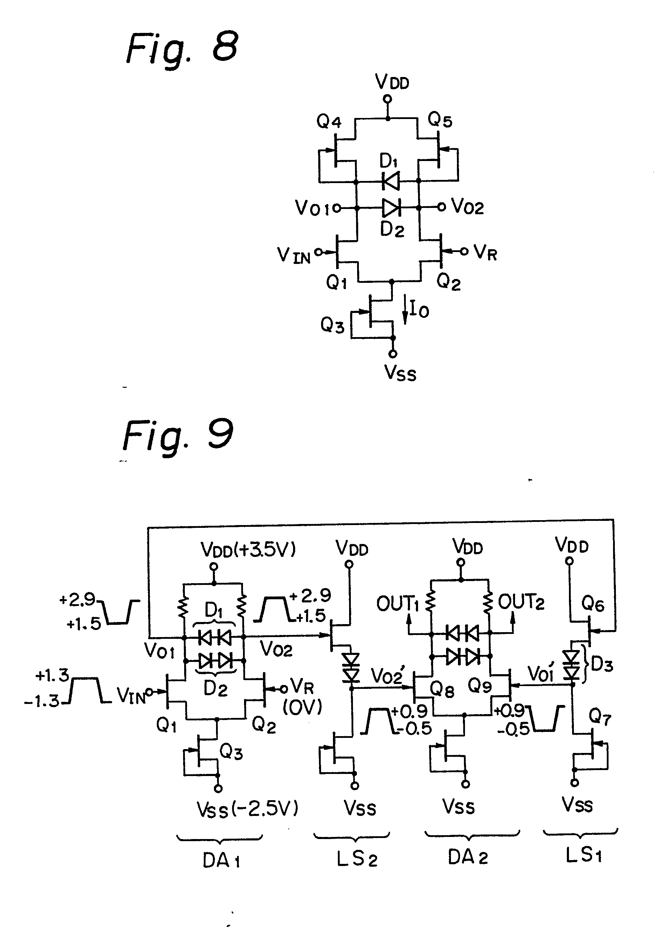

Figure 8 shows another embodiment of the invention in which, instead of a load resistor $R_L$ , depletion type FET's $Q_4$ , $Q_5$ wherein the gate and the source are short-circuited are used as the load. In this embodiment, a saturation drain current of the load FET's $Q_4$ , $Q_5$ is set to $I_L$ , the constant current source FET $Q_3$ thereof is set to $I_0$ , and thus the

following relationship is established.

$$I_0 > I_L \geq \frac{1}{2}I_0$$

The operation is the same as that shown in Fig. 4.
When the load resistor $R_L$ is replaced by a junction
type FET, the better characteristic of the FET can be
utilized, and a constant current load (which could not be
obtained by using /a MOSFET, which has a characteristic
similar to the resistor because of the bias effect
of the substrate) can be obtained. However, as the
constant current source $Q_3$ , which carries the flow of
the constant current $I_0$ , is used in the common source
circuit, when constant current source FET's $Q_4$ ,
$Q_5$ are used as the load, the operation point cannot be
determined. The above-mentioned condition $I_0 > I_L \geq I_0/2$
is effected to avoid this state, in which the current
value is determined by $Q_3$. Further, the symmetricity
of $V_{01}$ , $V_{02}$ to $V_{IN}$ is good when $I_L = I_0/2$, but when the
value is shifted to the $I_0$ side, this symmetricity is
deteriorated, and thus the input sensitivity is deteriorated. Therefore, it is preferable that $I_L$ is brought
as near to $I_L/2$ as possible. However, this is difficult
to accomplish with the conventional circuit, and when
the variation of the characteristic is taken into
consideration, $I_L$ must differ from $I_0/2$ to some extent.
Here, if the diodes $D_1$ , $D_2$ are used, the current
flowing in the diode when in an ON state flows into $Q_3$ ,
therefore, $I_L$ can be brought near to $I_0/2$.

Figure 9 shows a third embodiment of the invention
in which the two stage differential circuit shown in
Fig. 4 is connected in cascade. This embodiment provides
an initial stage differential amplifier circuit $DA_1$
which receives an input $V_{IN}$ and a next stage differential
amplifier circuit $DA_2$ which extracts the outputs $OUT_1$ ,
$OUT_2$. Between these circuits are level shift circuits
$LS_1$ , $LS_2$ in which the initial outputs $V_{01}$ , $V_{02}$ are
shifted by at least/ 2 V to the lower side and are matched to
the input level of the next stage. The amplitude $\Delta V_{OUT}$

of the output $V_{01}$ , $V_{02}$ is $|V_{01} - V_{02}|n \cdot V_{bi}$ , wherein $n$ is the number of the series connected diode $D_1$ (the same as $D_2$) which is used as a clamp. When $V_{DD} = +3.5$ V, $V_{SS} = -2.5$ V, $V_R = 0$ V, and $V_{bi} = 0.7$ V, $Vth = -0.6$ V for all FET, then the input $V_{IN}$ has the amplitude of $-1.3 \sim +1.3$ V, and the amplitude of the output $V_{01}$ , $V_{02}$ becomes $+1.5 \sim +2.9$ V ($V_{01}$ and $V_{02}$ are in reverse phase to each other). The level shift circuit $LS_1$ shifts the level of the input $V_{01}$ by about 2 V by $V_{bi}$ (= 0.7 V x 2) of the diode $D_3$ and the resistance series with the diode, and the output $V_{01}'$ having an amplitude of about $-0.5$ V $\sim +0.9$ V is obtained. This is the same as that of the other level shift circuit $LS_2$. The next stage differential amplifier circuit $DA_2$ is operated by two outputs, that is, the outputs $V_{01}'$, $V_{02}'$ of the level shift circuits $LS_1$ , $LS_2$ are given to $Q_8$ and $Q_9$ , which are used as driver FET's, and establish the relationships wherein $Q_8$ is ON and $Q_9$ is OFF. Thus it is clear that $V_{bi}$ is produced between the gate and source of the FET $Q_8$ and the potential difference $Vth$ is produced between the gate and the source of the FET $Q_9$. Therefore, as the second stage input voltage, it is sufficient that the relationship

$$V_{IN} = |V_{01}' - V_{02}'| \geqq V_{bi} - Vth$$

be satisfied. As the level shift circuits $LS_1$ , $LS_2$ do not change the amplitude ($\Delta V_{OUT} = \Delta V_{IN}$), then from the above equation, the relationship

$$n \cdot V_{bi} \geqq V_{bi} - Vth$$

can be introduced. This equation gives rise to the restriction wherein $n = 1$ thus $Vth \geqq 0$ (normally OFF), however if the $Vth < 0$ (normally OFF) FET is used, the relationship may be satisfied when $n \geqq 2$ is used. It is preferable to use the normally OFF type as the transistors $Q_1$ , $Q_2$ of the initial stage $DA_1$ of the two stage amplifier circuit, when the relationship to the prior stage is considered.

As mentioned above, according to the present invention, the low level output of the differential amplifier circuit used for driving the junction type FET can be stabilized, and since it is not necessary to increase the electric source voltage, it is also not necessary to increase the electric power dissipation. Further, as the amplitude is restricted, rapid operation can be carried out and the advantage of raising the voltage gain can be also obtained.

- 12 -                    0154501

CLAIMS

1. A logic circuit comprising:

a pair of transistors formed by junction type or Schottky barrier type field effect transistors;

a constant current source connected to a common source terminal of said field effect transistors;

a pair of load elements respectively connected between each drain terminal of said field effect transistors and a power supply; and

a clamp circuit connected between said drain terminals of said field effect transistors.

2. A logic circuit according to claim 1, wherein said clamp circuit is formed by two diodes connected in parallel between the drain terminals of said field effect transistors and having opposite polarities.

3. A logic circuit according to claim 1, wherein said clamp circuit is formed by two field effect transistors connected in parallel between the drain terminals of said field effect transistors, and a source and gate of said two field effect transistors are short circuited so as to form a cathode and the drain of said two field effect transistors is used as an anode, and said two field effect transistors are connected between said drain terminals of said field effect transistors with opposite polarity.

4. A logic circuit according to claim 1, 2, or 3, wherein said constant current source is formed by a field effect transistor having a source connected to a gate and a drain connected to said common source terminal.

5. A differential amplifier circuit comprising:

a pair of driver field effect transistors formed by junction type or Schottky barrier gate type field effect transistors;

a constant current source connected to a common source terminal of said pair of driver field effect transistors;

a pair of load elements respectively connected between each drain terminal of said driver field effect transistors and a power supply; and

two clamping diodes                connected between the drain terminals of said field effect transistors. and having opposite polarities.

6.    A logic circuit comprising first and second differential amplifiers, each of said differential amplifiers comprising a pair of transistors formed by junction type or Schottky barrier type field effect transistors having gate terminals as an input terminal, a constant current electric source connected to a common source terminal of said field effect transistors, a pair of load elements respectively connected between each drain terminal of said field effect transistors and an electr`- source and two outputs being made from the junction point betw en said load elements and said drain, and a clamp circuit connected between said drain terminals of said field effect transistors, a first and a second level shift circuits each comprising a first field effect transistor having a gate used as an input, a drain connected to an electric source, a level shift diode connected to a source of said first field effect transistor, a constant current source connected to said level shift diode, and an output terminal connected to a junction point between said level shift diode and said constant current source, an input being applied to an input terminal of said first differential amplifier, a reference voltage being applied to another input terminal of said first differential amplifier, the first and the second output terminals being connected to the input terminal of said level shift circuits, the outputs of said first and second level shift circuits being connected to two input terminals of said second differential amplifier, and the outputs generated from two output terminals of said second differential amplifier.

Fig. 1

Fig. 2

2/4                                    0154501

Fig. 3A          Fig. 3B

Fig. 3C          Fig. 3D

Fig. 3E          Fig. 3F

# Fig. 4

# Fig. 5

# Fig. 6

# Fig. 7

# Fig. 8

# Fig. 9